(19) Europäisches Patentamt
European Patent Office
Office européen des brevets

(11) **EP 1 846 774 B1**

(12) **EUROPÄISCHE PATENTSCHRIFT**

(45) Veröffentlichungstag und Bekanntmachung des Hinweises auf die Patenterteilung:
**26.04.2017   Patentblatt 2017/17**

(21) Anmeldenummer: **06706593.8**

(22) Anmeldetag: **02.02.2006**

(51) Int Cl.:
*G01R 35/00* (2006.01)      *G01R 27/32* (2006.01)

(86) Internationale Anmeldenummer:
**PCT/EP2006/000923**

(87) Internationale Veröffentlichungsnummer:
**WO 2006/084628 (17.08.2006 Gazette 2006/33)**

(54) **VERFAHREN UND ANORDNUNG ZUR KORREKTUR DER RÜCKWIRKUNG ELEKTRISCHER MESSWANDLER AUF DAS MESSOBJEKT**

METHOD AND DEVICE FOR ADJUSTING A MEASURING TRANSFORMER REACTION TO A MEASURED OBJECT

PROCEDE ET DISPOSITIF POUR CORRIGER LA REACTION DE TRANSFORMATEUR DE MESURE SUR L'OBJET A MESURER

(84) Benannte Vertragsstaaten:
**DE FR GB**

(30) Priorität: **09.02.2005   DE 102005005887**

(43) Veröffentlichungstag der Anmeldung:
**24.10.2007   Patentblatt 2007/43**

(73) Patentinhaber: **Rohde & Schwarz GmbH & Co. KG**
**81671 München (DE)**

(72) Erfinder: **REICHEL, Thomas**
**85598 Baldham (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
**EP-A- 0 333 521        EP-A- 1 569 005**
**WO-A-2004/100513        US-A- 5 734 268**
**US-A1- 2001 009 374**

**Beschreibung**

Die Erfindung betrifft ein Verfahren und eine Anordnung zur Korrektur der Rückwirkung elektrischer Messwandler auf das Messobjekt bei Messungen im HF- und Mikrowellenbereich sowie eine Anordnung zum Ausführen dieses Verfahrens und einen dafür geeigneten Messwandler.

Die Messtechnik ist stets mit dem Problem konfrontiert, dass Messungen Rückwirkungen auf das Messobjekt haben. Deswegen werden Messgeräte so gebaut, dass diese Rückwirkung möglichst klein ist: Spannungsmessgeräte haben eine hohe Eingangsimpedanz, Leistungsmessgeräte einen Impedanzwert, der möglichst so groß ist wie die Nennimpedanz des Bezugssystems (z.B. 50 $\Omega$). Während es im niederfrequenten Bereich schon seit langem möglich ist, dem idealerweise benötigten Impedanzwert sehr nahe zu kommen, d.h. quasi rückwirkungsfrei zu arbeiten, ist dies im HF- und Mikrowellenbereich nur begrenzt möglich. So bewirken die konstruktiv bedingten parasitären Eingangskapazitäten von Oszilloskop-Tastköpfen, dass der Impedanzwert im GHz-Bereich unter das 1-k$\Omega$-Niveau sinkt. Bei Mikrowellen-Leistungsmessköpfen sind es z.B. die mechanischen Toleranzen der Anschlussstecker, die eine untere Grenze für die erzielbare Anpassung setzen.

Aus der US 2001/0009374 A1 ist bereits eine Anordnung mit einem elektrischen Messwandler bekannt. Dort erfolgt die Messung des Reflexionskoeffizienten eines Messobjekts durch Messung des Spannungsverhältnisses im Messgerät. Bei der eigentlichen Messung wird lediglich das Messobjekt mit nur einer einzigen unbekannten Eingangsimpedanz an das Messgerät angeschaltet.

Die US 5,734,268 hat einen Netzwerkanalysator zum Gegenstand, bei dem das Übersprechen zwischen den Messspitzen durch eine spezielle Art der Kalibrierung beseitigt werden soll. Auch hier werden nacheinander vor der eigentlichen Messung anstelle des eigentlichen Messobjekts mehrere Kalibrierstandarts nacheinander angeschaltet.

Leistungsmessköpfe (genauer: Abschlussleistungsmessköpfe) werden dazu verwendet, die Nennleistung einer Quelle zu messen. Das ist jene Leistung, welche die Quelle bei wellenwiderstandsrichtiger Anpassung abgeben kann. einfallenden Welle mit geringer Unsicherheit gemessen werden kann.

Ein zweiter mit der Fehlanpasssung des Leistungsmesskopfes verknüpfter Effekt lässt sich aber nicht so leicht rückgängig machen: Die zur Quelle zurückreflektierte Welle kann dort ein weiteres Mal reflektiert werden und sich der auf den Leistungsmesskopf einfallenden Welle überlagern, so dass sich die Leistung der Quelle ändert, diese also nicht mehr ihre Nennleistung abgibt (Rückwirkung des Messkopfes auf das Messobjekt). Die Höhe der Abweichung wird durch Betrag und Phase der Reflexionskoeffizienten von Messkopf und Quelle bestimmt. Folgende mathematische Beziehungen beschreiben den Zusammenhang:

$$|a_i|^2 = \frac{P_{GZ0}}{|1 - \Gamma_G \Gamma_S|^2} \qquad (2)$$

$$P_{GZ0} = \frac{X}{S} \cdot |1 - \Gamma_G \Gamma_S|^2 \qquad (3)$$

$P_{GZ0}$    Nennleistung der Quelle (bei Anpassung)
$\Gamma_G$    Komplexer Reflexionskoeffizient der Quelle
$\Gamma_S$    Komplexer Reflexionskoeffizient des Leistungsmesskopfes

Die durch Rückwirkung entstehenden Messabweichungen sind bei niedrigen Frequenzen, wo sich kleine Reflexionskoeffizienten einfach realisieren lassen, meist vernachlässigbar. Im Mikrowellenbereich können sich jedoch Messabweichungen ergeben, welche die spezifizierte Unsicherheit des Messkopfes für die einfallende Welle um ein Vielfaches überschreiten. So kann bei einem Messkopf mit einem Reflexionskoeffizienten von 0,13 (Spezifikation für R&S NRP-Z55 bei 40 GHz) und einer Quelle mit einem Reflexionskoeffizienten von 0,33 (SWR 2,0) eine Messabweichung im Bereich von -8,9 % ...+9,3 % auftreten. Das ist deutlich mehr als die für diesen Messkopf spezifizierte Messunsicherheit (für die einfallende Welle) in Höhe von etwa 2,5 %.

Es sind zwei Methoden bekannt, den Einfluss der Rückwirkung zu verringern:

1. Die entstehende Messabweichung wird unter Zuhilfenahme von Gl. (3) nachträglich rückgängig gemacht. Dies setzt voraus, dass die komplexen Reflexionskoeffizienten von Quelle und Leistungsmesskopf nach Betrag und Phase (Real- und Imaginärteil) bekannt sind. Für den Leistungsmesskopf ist diese Forderung leicht zu erfüllen, da der Reflexionskoeffizient im Rahmen des Produktionsprozesses ohnehin gemessen werden muss und häufig auch protokolliert wird. Die Anmelderin speichert z.B. bisher für die Messköpfe der Leistungsmesser-Familie NRP die komplexen Reflexionskoeffizienten im Datenspeicher des Messkopfes und kann dann die o.g. Korrekturmöglichkeit anbieten. Dazu muss aber der Reflexionskoeffizient der Quelle eingegeben - d.h. vorher gemessen werden -, was das eigentliche Problem bei dieser Methode ist. Abgesehen davon, dass es lästig sein kann, diese Größe messen zu müssen, wenn gerade kein Netzwerkanalysator verfügbar oder keine Zeit für eine solche Messung vorhanden ist, kann häufig diese Messung gar nicht so ohne weiteres mit einem Standard-Messverfahren durchgeführt werden, weil es sich ja um den Reflexionskoeffizienten einer Quelle handelt. Dafür gibt es zwar auch Methoden, aber man kann i.Allg. nicht davon ausgehen, dass diese bekannt sind und/oder das dafür erforderliche Equipment vorhanden ist. Zusammengefasst wird diese Korrekturmethode nur dort zum Einsatz kommen, wo sich der höhere Aufwand auch wirklich lohnt.

2. Mit Hilfe eines vor den Messkopf geschalteten Tuners wird dessen Reflexionskoeffizient bei der Messfrequenz auf Null abgeglichen, so dass keine Messfehler durch Fehlanpassung entstehen können. Auch hier wird ein Netzwerkanalysator benötigt, und zwar zur Einstellung des Tuners. Erschwerend kommt bei dieser Methode hinzu, dass die Tuner-Einstellung frequenzabhängig ist, d.h. bei Leistungsmessungen an unterschiedlichen Frequenzpunkten jedesmal der Tuner neu eingestellt werden muss. Für die praktische Durchführung ist also ein fernsteuerbarer Tuner kaum zu umgehen. Die Methode wird vereinzelt in Kalibrierlaboratorien angewandt, die erreichbare Messgenauigkeit ist vergleichbar mit jener, die vorstehend unter 1 beschrieben wurde.

Es ist die Aufgabe der Erfindung, ein Verfahren aufzuzeigen mit dem ohne großen Aufwand diese störende Rückwirkung von elektrischen Messwandlern auf das Messobjekt korrigiert werden kann. Außerdem soll eine einfache Anordnung und ein hierfür geeigneter Messwandler zur Korrektur solcher Rückwirkungen aufgezeigt werden.
Diese Aufgabe wird ausgehend von einem Verfahren laut Oberbegriff des Anspruchs 1 durch dessen kennzeichnende Merkmale gelöst. Vorteilhafte Weiterbildungen insbesondere für einen Leistungsmesskopf bzw. einen Oszilloskop-Tastkopf ergeben sich aus den Unteransprüchen. Eine besonders einfache Anordnung zum Ausführen eines solchen Verfahrens sowie für den Aufbau eines hierfür geeigneten Messwandlers ergeben sich aus den Ansprüchen 5 und 11.
Mit dem erfindungsgemäßen Verfahren kann auf einfache Weise die Rückwirkung eines elektrischen Messwandlers, beispielsweise eines Leistungsmesskopfes oder eines Oszilloskop-Tastkopfes, auf das Messobjekt berechnet und so aus dem Messergebnis eliminiert werden. Mit dem erfindungsgemäßen Verfahren kann beispielsweise bei einem Leistungsmesskopf die Nennleistung der Quelle nacheinander mit unterschiedlich angepasstem Messkopf gemessen werden und so die Messgenauigkeit erhöht werden. Dazu wird der Messkopf so ausgelegt, dass er sich in mindestens drei unterschiedlichen Konfigurationen mit unterschiedlicher Eingangsimpedanz betreiben lässt. Diese mindestens drei unterschiedlichen Konfigurationen werden so gewählt, dass sich jeweils entsprechend unterschiedliche Reflektionskoeffizienten ergeben, so dass sich die bezüglich ihrer Leistung zu messende Quelle mit mehr oder weniger großen Änderungen der hinlaufenden Welle auf diese unterschiedlichen Reflektionskoeffizienten reagiert und sich so entsprechend unterschiedliche Rohmesswerte ergeben.
Die Erfindung wird im Folgenden anhand schematischer Zeichnungen an Ausführungsbeispielen näher erläutert.

Fig. 1    zeigt eine bekannte Anordnung zur Leistungsmessung mittels eines Leistungsmesskopfes,

Fig. 2    zeigt eine erfindungsgemäß erweiterte Messanordnung dieser Art,

Fig. 3    zeigt das für einen solchen Messkopf mit drei aufeinander folgenden Messungen sich ergebende Reflektionsfaktor-Diagram,

Fig. 4    zeigt eine erste praktische Lösungsmöglichkeit für einen erfindungsgemäßen Leistungsmesskopf,

Fig. 5    zeigt die Anwendung der Erfindung bei einem Oszilloskop-Tastkopf

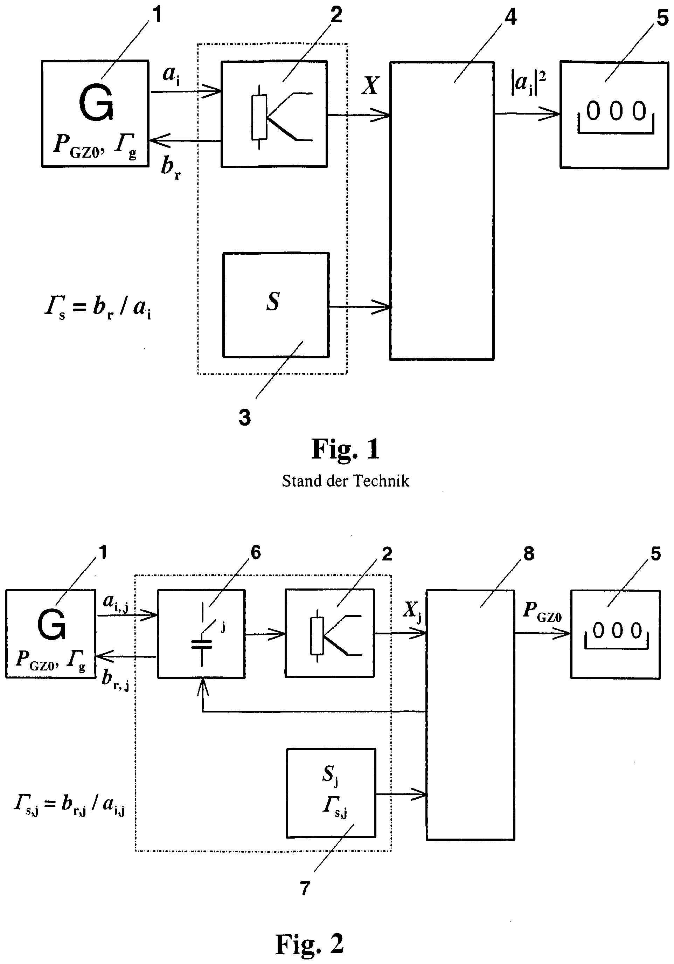

Fig. 1 zeigt das Prinzipschaltbild einer bekannten Anordnung zur Nennleistungsmessung eines HF- bzw. Mikrowellengenerators 1. Sie umfasst einen Leistungsdetektor 2, der beispielsweise nach dem thermischen Prinzip arbeitet und die zu messende Leistung in Wärme umsetzt. Diesem Leistungsdetektor 2 ist ein Datenspeicher 3 zugeordnet, in welchem Kenndaten des Detektors gespeichert sind, beispielsweise die Empfindlichkeit S. Detektor 2 und Datenspeicher 3 sind mit einer Auswert- und Steuereinheit 4 verbunden, in welcher die Leistung der einfallenden Welle des Generators 1 berechnet wird, die dann in der Anzeige- und Ausgabeeinrichtung 5 weiter verarbeitet wird.
Fig. 2 zeigt eine erfindungsgemäße Messanordnung, bei welcher dem Leistungsdetektor 2 eine Baugruppe 6 zum Verändern seiner Eingangsimpedanz zugeordnet ist. Mittels dieser Baugruppe 6 kann der Messkopf 2 in mindestens drei Konfigurationen j mit unterschiedlichen Eingangsimpedanzen betrieben werden. Im Datenspeicher 7 sind für jede Konfiguration j die komplexen Reflexionskoeffizienten und die zugehörigen Empfindlichkeiten gespeichert, die durch eine vorausgehende Kalibrierung bestimmt worden sind.

Die Auswertung erfolgt mit einem auf Gl. (3) basierenden Gleichungssystem für die drei Unbekannten $P_{\text{GZ0}}$, $\text{Re}\,\Gamma_G$ und $\text{Im}\,\Gamma_G$:

$$P_{GZ0} = \frac{X_{\mathrm{j}}}{S_{\mathrm{j}}} \cdot \left| 1 - \left( \text{Re}\,\Gamma_G + j \,\text{Im}\,\Gamma_G \right) \Gamma_{\mathrm{s,j}} \right|^2 \qquad (4)$$

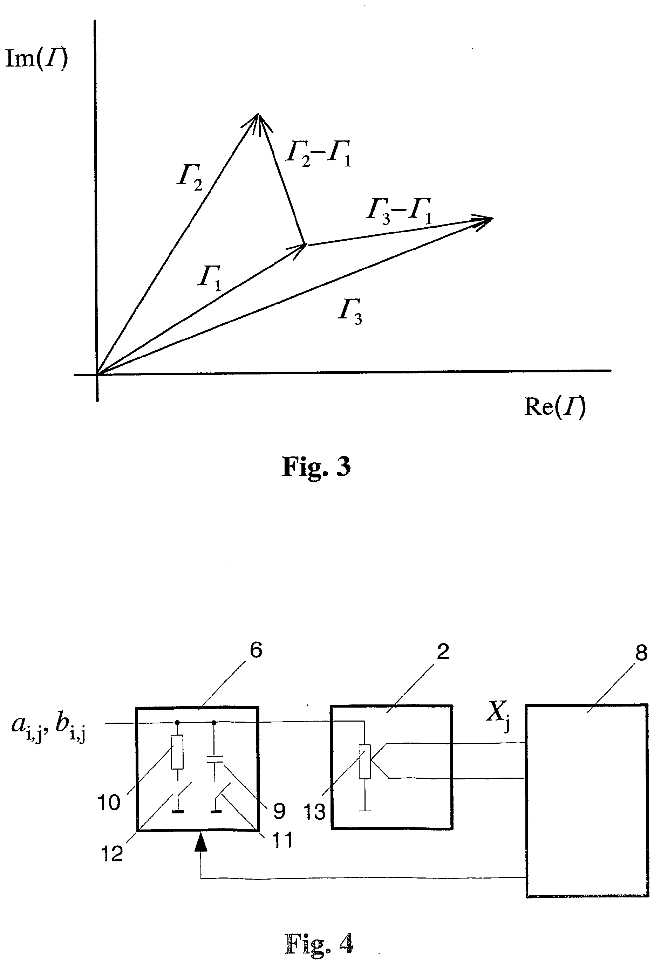

Damit das Gleichungssystem lösbar ist, müssen Rohmesswerte $X$ aus mindestens drei unterschiedlichen Konfigurationen vorliegen. Ferner müssen für jede Konfiguration die komplexen Reflexionskoeffizienten $\Gamma_{s,j}$ und die zugehörigen Empfindlichkeiten $S_{\mathrm{j}}$ bekannt sein, welche sich durch eine Kalibrierung während des Produktionsprozesses bestimmen lassen. Bei vier oder mehr Konfigurationen ist das Gleichungssystem überbestimmt. Die Redundanz lässt sich zum Ausgleich von Messfehlern bei der Bestimmung der $X_{\mathrm{j}}$, $\Gamma_{\mathrm{s,j}}$ und $S_{\mathrm{j}}$ verwenden. Im Normalfall werden drei oder vier Konfigurationen vorgesehen. Zum Zwecke hoher Messgenauigkeit ist es dabei vorteilhaft, wenn sich der Reflexionskoeffizient ausgehend von der Konfiguration 1 so ändert, dass zwei Änderungsvektoren, z.B. $\Gamma_{S,2} - \Gamma_{S,1}$ und $\Gamma_{S,3} - \Gamma_{S,1}$, einen Winkel von 30° bis 150° - idealerweise 90° - einschließen (siehe Fig. 3) und so groß sind, dass sich im Falle starker Rückwirkung eine messbare Änderung für die Leistung $|a_{\mathrm{i}}|^2$ der einfallenden Welle ergibt. Der Entwurf einer solchen dem Leistungssensor vorgeschalteten Baugruppe und deren Auslegung ist einem Fachmann auf dem Gebiet der Hochfrequenz- und Mikrowellenmesstechnik bekannt.

In der Auswerte- und Steuereinheit 8, werden aus den Rohmesswerten $X_{\mathrm{j}}$ und den gespeicherten Werten $S_{\mathrm{j}}$ und $\Gamma_{\mathrm{s,j}}$ die gesuchte Größe $P_{\text{Gz0}}$ anhand des Gleichungssystems 4 ermittelt und der Ausgabeeinheit 5 zur Verfügung gestellt.

Die Baugruppe 6 ist so auszulegen, dass sich einerseits das Übertragungsverhalten des Messkopfes für die verschiedenen Konfigurationen nicht wesentlich unterscheidet und andererseits solche Änderungen des Reflexionsfaktors hervorgerufen werden (s.o.), dass eine genaue Bestimmung der Nennleistung $P_{\text{GZ0}}$ möglich ist. Von den vielen Realisierungsmöglichkeiten zeigt Fig. 4 eine Lösung, bei der parallel zum Abschlusswiderstand 13 des Leistungsdetektors 2 eine Kapazität 9 und/oder ein ohmscher Widerstand 10 geschaltet werden können. Beide Elemente werden so bemessen, dass sich der eingangsseitige Reflexionskoeffizient beim Zuschalten in der Größenordnung von 0,03 bis 0,3 ändert. Die 90°-Bedingung ist automatisch erfüllt. Insgesamt ergeben sich mit dieser Anordnung vier Konfigurationen, wobei eine redundant ist:

| Konfiguration | Schalter 12 | Schalter 11 |
|---|---|---|
| 1 | Aus | Aus |
| 2 | Aus | Ein |
| 3 | Ein | Aus |
| 4 | Ein | Ein |

Die erfindungsgemäße Maßnahme kann auch für Tastköpfe von Oszilloskopen angewendet werden, allerdings ist die Auswertung umfangreicher. Während bei der Leistungsmessung die Kurvenform des Signals bekannt ist (Sinusschwingung einer bestimmten Frequenz) und lediglich dessen Höhe (Effektivwert, Leistung) zu bestimmen ist, werden Oszilloskopen in der Regel komplexe, i.a. nicht sinusförmige Signale zugeführt. Es handelt sich also um ein Frequenzgemisch, dessen einzelne spektrale Komponenten durch die Belastung der Quelle mit der Eingangsimpedanz des Tastkopfes in unterschiedlicher Weise gedämpft oder verstärkt und in ihrer Phasenlage geändert werden. Somit sind alle - oder zumindest alle relevanten - spektralen Komponenten der Messgröße sowie die bei diesen Frequenzen vorhandenen Werte der Quellimpedanz zu bestimmen.

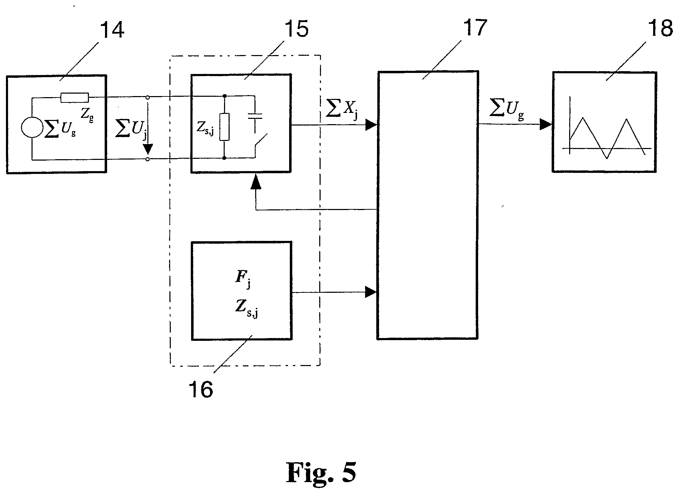

Eine erfindungsgemäße Schaltung zeigt Fig. 5. An den Ausgang einer Quelle 14 mit der Leerlaufspannung $\Sigma U_g(f)$ (Summe aller spektralen Komponenten) und der Ausgangsimpedanz $Z_g(f)$ ist ein Tastkopf 15 angeschlossen, dessen Eingangsimpedanz sich in mindestens drei Stufen verändern lässt. Für jede dieser Stufen ($j$) ist die Eingangsimpedanz $Z_{\mathrm{s,j}}(f)$ und das komplexe Übertragungsmaß

$$F_j(f) = \frac{X_j(f)}{U_j(f)} \tag{5}$$

als Verhältnis der Ausgangsgröße $X$ und der Eingangsgröße $U$ bekannt und im Speicher 16 gespeichert. In der Mess- und Auswerteeinheit 17 wird die Ausgangsgröße X für mindestens drei Konfiguration erfasst und jeweils in ihre spektralen Komponenten zerlegt. Für eine Frequenz f gilt dabei:

$$X_j(f) = F(f) \cdot \frac{Z_{s,j}(f)}{Z_{s,j}(f) + Z_g(f)} \cdot U_g(f) \tag{6}$$

$$U_g(f) = \frac{1}{F(f)} \cdot \frac{Z_{s,j}(f) + Z_g(f)}{Z_{s,j}(f)} \cdot X_j(f) \tag{7}$$

Auch hier lassen sich die drei Unbekannten - $U_g$, Re(Zg) und Im($Z_g$) - für jede Spektralkomponente aus den Ergebnissen der drei Messungen berechnen. Sind die spektralen Komponenten von $U_g$ erst einmal bekannt, kann die komplexe Leerlaufspannung der Quelle selbst durch Summation der einzelnen Komponenten bestimmt und auf eine Anzeigeeinrichtung 18 ausgegeben werden.

Analog zu der Bedingung, dass die Änderung des komplexen Eingangs-Reflexionsfaktors bei einem erfindungsgemäßen Leistungsmesskopf so erfolgen sollte, dass die Änderungsvektoren idealerweise rechtwinklig zueinander sind, ist dies hier für die Änderung der komplexen Eingangsimpedanz zu fordern d.h. für $Z_{s,2}$ - $Z_{s,1}$ und $Z_{s,3}$ - $Z_{s,1}$.

Das erfindungsgemäße Prinzip lässt sich auch bei anderen Arten von Messwandlern anwenden, indem der Messwandler mit einer Einrichtung versehen wird, die die Rückwirkung gezielt verändert. Die Anzahl der unterschiedlichen Konfigurationen richtet sich dabei nach der Zahl der Unbekannten im System der Übertragungsgleichungen. Das oben beschriebene Problem der Orthogonalität lässt sich auf die Forderung nach einem linear unabhängigen Gleichungssystem zurückführen. Die Erfindung ist daher nicht auf die beschriebenen Ausführungsbeispiele beschränkt. Alle beschriebenen oder gezeichneten Elemente sind beliebig miteinander kombinierbar.

## Patentansprüche

1. Verfahren zur Korrektur der Rückwirkung elektrischer Messwandler (2, 15) auf das Messobjekt (1, 14) bei Messungen im HF- bzw. Mikrowellenbereich,
   **dadurch gekennzeichnet,**
   **dass** an den Ausgang des Messobjekts (1, 14) ein Tastkopf (15) eines Messwandlers (2, 15) angeschlossen wird, dessen Eingangsimpedanz in mindestens drei Stufen veränderbar ist, und
   **dass** mindestens drei Messungen des Messobjekts (1, 14) mit jeweils unterschiedlichen Eingangsimpedanzen des Messwandlers durchgeführt werden und daraus dann der rückwirkungsfreie Messwert berechnet wird.

2. Verfahren nach Anspruch 1,
   **dadurch gekennzeichnet,**
   **dass** vier oder mehr Messungen mit jeweils unterschiedlichen Eingangsimpedanzen des Messwandlers durchgeführt werden und die sich dadurch ergebende Redundanz zum Ausgleich von Messfehlern benutzt wird.

3. Verfahren nach Anspruch 1 oder 2 zur Korrektur der Rückwirkung eines Leistungsmesswandlers auf die zu messende Quelle,
   **dadurch gekennzeichnet,**
   **dass** mindestens drei Messungen mit jeweils unterschiedliche komplexe Reflektionskoeffizienten ergebenden unterschiedlichen Eingangsimpedanzen des Leistungsmesswandlers durchgeführt werden und aus diesen mindestens drei Leistungsmessungen sowie diesen drei komplexen Reflektionskoeffizienten und zugehörigen Empfindlichkeiten des Leistungsmesswandlers die Nennleistung der Quelle berechnet wird.

4. Verfahren nach Anspruch 1 oder 2 zur Korrektur der Rückwirkung eines Oszilloskop-Tastkopfes auf das zu messende Messobjekt beim Messen von nicht sinusförmigen Messsignalen,
**dadurch gekennzeichnet,**
**dass** mindestens drei Messungen mit jeweils unterschiedlichen Eingangsimpedanzen des Tastkopfes durchgeführt werden und aus diesen mindestens drei Messungen sowie dem für diese drei Messungen bekannten komplexen Übertragungsmaß des Tastkopfes die Lehrlaufspannung der einzelnen spektralen Komponenten des Messsignals und daraus schließlich die komplexe Lehrlaufspannung des Messsignals berechnet werden.

5. Anordnung, zum Ausführen eines Verfahrens nach einem der Ansprüche 1 bis 4, mit einem Messwandler (2, 15), einem Datenspeicher (7, 16) für bekannte Kenndaten des Messwandlers, einer mit dem Messwandler und diesem Datenspeicher verbundenen Auswert- und Steuereinrichtung (8, 7) sowie einer Ausgabe- und Anzeigeeinrichtung (5, 18),
**dadurch gekennzeichnet,**
**dass** an den Ausgang des Messobjekts (1, 14) ein Tastkopf (15) des Messwandlers (2, 15) anschließbar ist, dessen Eingangsimpedanz in mindestens drei Stufen veränderbar ist, und
**dass** die Anordnung eine Einrichtung (6) zum Umschalten der Eingangsimpedanz des Messwandlers auf mindestens drei unterschiedliche Eingangsimpedanzwerte umfasst und besagte Einrichtung (6) dem Messwandler (2, 15) zugeordnet ist.

6. Anordnung nach Anspruch 5,
**dadurch gekennzeichnet,**
**dass** die Einrichtung (6) zum Umschalten der Eingangsimpedanz des Messwandler über Schalter (11, 12) zu- und abschaltbare unterschiedliche Kapazitäten (9) und/oder ohmsche Widerstände (10) aufweist.

7. Anordnung nach Anspruch 5 oder 6 für einen Leistungsmesswandler (2),
**dadurch gekennzeichnet,**
**dass** für die mindestens drei unterschiedlichen Eingangsimpedanzwerte im Datenspeicher (7) die zughörigen Werte für Empfindlichkeit (S) und für den jeweiligen zugehörigen komplexen Reflektionskoeffizienten ($\Gamma$) des Leistungsmesswandlers gespeichert sind.

8. Anordnung nach Anspruch 7,
**dadurch gekennzeichnet,**
**dass** die unterschiedlichen Eingangsimpedanzwerte des Leistungsmesswandlers (2) so gewählt sind, dass die Änderungsvektoren der sich dadurch ergebenden unterschiedlichen komplexen Reflektionskoeffizienten einen Winkel zwischen 30° und 150°, vorzugsweise 90°, einschließen.

9. Anordnung nach Anspruch 5 und 6 für einen Oszilloskop-Tastkopf,
**dadurch gekennzeichnet,**
**dass** im Datenspeicher (16) für die mindestens drei unterschiedlichen Eingangsimpedanzwerte des Tastkopfes der zugehörige Eingangsimpedanzwert und das komplexe Übertragungsmaß gespeichert sind.

10. Anordnung nach Anspruch 9,
**dadurch gekennzeichnet,**
**dass** die unterschiedlichen Eingangsimpedanzwerte des Tastkopfes so gewählt sind, dass die Änderungsvektoren der sich dadurch ergebenden unterschiedlichen komplexen Eingangsimpedanzen einen Winkel zwischen 30° und 150°, vorzugsweise 90°, einschließen.

11. Messwandler zum Ausführen eines Verfahrens nach einem der Ansprüche 1 bis 4 bzw. für eine Anordnung nach einem der Ansprüche 5 bis 10,
**gekennzeichnet durch**,
eine ihm zugeordnete Einrichtung (6) zum Umschalten seiner Eingangsimpedanz auf mindestens drei unterschiedliche Eingangsimpedanzwerte.

**Claims**

1. Method for correcting the feedback from electrical measurement converters (2, 15) to the object being measured (1, 14) when carrying out measurements in the high-frequency or microwave range,

**characterised in that** a measuring head (15) of a measurement converter (2, 15) the input impedance of which can be adjusted in at least three stages is connected to the output of the object being measured (1, 14), and **in that** at least three measurements are carried out on the object being measured (1, 14) each at different input impedance values of the measurement converter and these are then used to calculate the feedback-free measurement value.

2. Method according to claim 1,
**characterised in that** four or more measurements are carried out each at different input impedance values of the measurement converter and the resulting redundancy is used to offset measurement errors.

3. Method according to claim 1 or 2 for correcting the feedback from a power measurement converter to the source being measured,
**characterised in that** at least three measurements are carried out each at different input impedance values of the power measurement converter resulting in different complex reflection coefficients and these at least three power measurements and these three complex reflection coefficients and associated sensitivity levels of the power measurement converter are used to calculate the rated power of the source.

4. Method according to claim 1 or 2 for correcting the feedback from an oscilloscope probe head to the object being measured when measuring non-sinusoidal measurement signals,
**characterised in that** at least three measurements are carried out each at different input impedance values of the probe head and these at least three measurements and the complex transmission factor of the probe head known for these three measurements are used to calculate the open circuit voltage of the individual spectral components of the measurement signal and this is used lastly to calculate the complex open circuit voltage of the signal being measured.

5. Arrangement for implementing a method according to one of claims 1 to 4, with a measurement converter (2, 15), a data memory (7, 16) for known characteristic data of the measurement converter, an evaluation and control unit (8, 7) connected with the measurement converter and this data memory, and an outputting and display unit (5, 18), **characterised in that** a measuring head (15) of the measurement converter (2, 15) the input impedance of which can be adjusted in at least three stages can be connected to the output of the object being measured (1, 14), and **in that** the arrangement comprises a unit (6) for switching over the input impedance of the measurement converter to at least three different input impedance values and said unit (6) is associated with the measurement converter (2, 15).

6. Arrangement according to claim 5,
**characterised in that** the unit (6) for switching over the input impedance of the measurement converter has different capacitors (9) and/or ohmic resistors (10) which can be switched on and off by means of switches (11, 12).

7. Arrangement according to claim 5 or 6 for a power measurement converter (2),
**characterised in that** for the at least three different input impedance values the associated values for sensitivity (S) and for the respective associated complex reflection coefficient (r) of the power measurement converter are stored in the data memory (7).

8. Arrangement according to claim 7,
**characterised in that** the different input impedance values of the power measurement converter (2) are selected so that the change vectors of the different complex reflection coefficients resulting therefrom enclose an angle of between 30° and 150°, preferably 90°.

9. Arrangement according to claim 5 and 6 for an oscilloscope probe head,
**characterised in that** for the at least three different input impedance values of the probe head the associated input impedance value and the complex transmission factor are stored in the data memory (16).

10. Arrangement according to claim 9,
**characterised in that** the different input impedance values of the probe head are selected so that the change vectors of the different complex input impedance values resulting therefrom enclose an angle of between 30° and 150°, preferably 90°.

11. Measurement converter for implementing a method according to one of claims 1 to 4 or for an arrangement according to one of claims 5 to 10,
**characterised by** an associated unit (6) for switching over its input impedance to at least three different input impedance values.

## Revendications

1. Procédé de correction de la réaction de transformateurs de mesure (2, 15) électriques sur l'objet à mesurer (1, 14) lors de mesures dans le domaine haute fréquence ou micro-ondes,
**caractérisé en**
ce qu'une sonde (15) d'un transformateur de mesure (2, 15), dont l'impédance d'entrée peut varier dans au moins trois niveaux, est raccordée à la sortie de l'objet à mesurer (1, 14), et
ce qu'au moins trois mesures de l'objet à mesurer (1, 14) comprenant chacune des impédances d'entrée différentes du transformateur de mesure sont effectuées et la valeur de mesure sans réaction en est ensuite déduite.

2. Procédé selon la revendication 1,
**caractérisé en**
ce que quatre mesures ou plus comprenant chacune des impédances d'entrée différentes du transformateur de mesure sont effectuées et la redondance qui en découle est utilisée pour compenser les erreurs de mesure.

3. Procédé selon la revendication 1 ou 2 de correction de la réaction d'un transformateur de mesure de puissance sur la source à mesurer,
**caractérisé en**
ce qu'au moins trois mesures comprenant chacune des impédances d'entrée différentes du transformateur de mesure de puissance produisant des coefficients de réflexion complexes différents sont effectuées et la puissance nominale de la source est déduite de ces au moins trois mesures de puissance ainsi que de ces trois coefficients de réflexion complexes et des sensibilités associées du transformateur de mesure de puissance.

4. Procédé selon la revendication 1 ou 2 de correction de la réaction d'une sonde d'oscilloscope sur l'objet à mesurer lors de la mesure de signaux de mesure non sinusoïdaux,
**caractérisé en**
ce qu'au moins trois mesures comprenant chacune des impédances d'entrée différentes de la sonde sont effectuées et la tension en circuit ouvert de la composante spectrale individuelle du signal de mesure est déduite de ces au moins trois mesures ainsi que de la grandeur de transmission complexe connue pour ces trois mesures de la sonde et la tension en circuit ouvert complexe du signal de mesure en est finalement déduite.

5. Ensemble, permettant la mise en oeuvre d'un procédé selon l'une quelconque des revendications 1 à 4, comprenant un transformateur de mesure (2, 15), une mémoire de données (7, 16) pour des données caractéristiques connues du transformateur de mesure, un dispositif d'évaluation et de commande (8, 7) relié au transformateur de mesure et à cette mémoire de données ainsi qu'un dispositif d'édition et d'affichage (5, 18),
**caractérisé en**
ce qu'une sonde (15) du transformateur de mesure (2, 15), dont l'impédance d'entrée peut varier dans au moins trois niveaux, peut être raccordée à la sortie de l'objet à mesurer (1, 14), et
ce que l'ensemble comporte un dispositif (6) permettant de commuter l'impédance d'entrée du transformateur de mesure sur au moins trois valeurs d'impédance d'entrée différentes et ledit dispositif (6) est associé au transformateur de mesure (2, 15).

6. Ensemble selon la revendication 5,
**caractérisé en**
ce que le dispositif (6) permettant de commuter l'impédance d'entrée du transformateur de mesure par l'intermédiaire de commutateurs (11, 12) comprend différentes capacités (9) et/ou résistances ohmiques (10) pouvant être désactivées et activées.

7. Ensemble selon la revendication 5 ou 6 pour un transformateur de mesure de puissance (2),
**caractérisé en**
ce que pour lesdites au moins trois valeurs d'impédance d'entrée différentes, les valeurs associées pour la sensibilité (S) et pour les coefficients de réflexion ($\Gamma$) complexes associés respectifs du transformateur de mesure de puissance sont mises en mémoire dans la mémoire de données (7).

8. Ensemble selon la revendication 7,
   **caractérisé en**
   **ce que** les valeurs d'impédance d'entrée différentes du transformateur de mesure de puissance (2) sont sélectionnées de sorte que les vecteurs de variation des coefficients de réflexion complexes différents en découlant forment un angle compris entre 30° et 150°, de préférence de 90°.

9. Ensemble selon les revendications 5 et 6 pour une sonde d'oscilloscope,
   **caractérisé en**
   **ce que** la valeur d'impédance d'entrée associée et la grandeur de transmission complexe sont mises en mémoire dans la mémoire de données (16) pour lesdites au moins trois valeurs d'impédance d'entrée différentes de la sonde.

10. Ensemble selon la revendication 9,
    **caractérisé en**
    **ce que** les valeurs d'impédance différentes de la sonde sont sélectionnées de sorte que les vecteurs de variation des impédances d'entrée complexes différentes qui en découlent forment un angle compris entre 30° et 150°, de préférence de 90°.

11. Transformateur de mesure permettant de mettre en oeuvre un procédé selon l'une quelconque des revendications 1 à 4 ou pour un ensemble selon l'une quelconque des revendications 5 à 10,
    **caractérisé par**
    un dispositif (6) qui lui est associé et qui permet de commuter son impédance d'entrée sur au moins trois valeurs d'impédance d'entrée différentes.

**Fig. 1**

Stand der Technik

$$\Gamma_s = b_r / a_i$$

**Fig. 2**

$$\Gamma_{s,j} = b_{r,j} / a_{i,j}$$

**Fig. 3**

**Fig. 4**

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20010009374 A1
- US 5734268 A